# FASCICULE DE BREVET EUROPEEN

(11) **EP 3 290 253 B1**
(45) Date de publication et mention de la délivrance du brevet: **01.05.2019**
(21) Numéro de dépôt: 17187000.9
(22) Date de dépôt: 21.08.2017
(51) Int. Cl.: B60K 37/06, H03K 17/96

(54) **PANNEAU DE COMMANDE POUR VEHICULE AUTOMOBILE**
BEDIENUNGSFELD FÜR KRAFTFAHRZEUG
CONTROL PANEL FOR A MOTOR VEHICLE

(30) Priorité: 29.08.2016 FR 1658013
(43) Date de publication de la demande: 07.03.2018
(73) Titulaire: Aptiv Technologies Limited, St. Michael (BB)
(72) Inventeur: BORON, Artur, 32-070 Czernichów (PL); LIPKA, Janusz, 02-066 Warsaw (PL); MADON, Przemyslaw, 31-610 Kraków (PL); MELFRIED, Sebastian, 30-838 Kraków (PL); NIEMIEC, Halina, 30-399 Kraków (PL); SZOSTEK, Grzegorz, 32-084 Morawica (PL)
(74) Mandataire: Robert, Vincent

(56) Documents cités:
- WO-A1-2012/085360
- WO-A1-2015/110722
- WO-A2-2010/014356

## Description

### DOMAINE TECHNIQUE

La présente invention concerne un panneau de commande automobile et plus particulièrement un panneau de commande rétroéclairé équipé de boutons capacitifs.

### ARRIERE-PLAN TECHNOLOGIQUE DE L'INVENTION

Des dispositifs de commandes ou panneau de commande à boutons capacitifs sont connus de l'art antérieur. De tels dispositifs comprennent généralement une façade frontale transparente peinte sur sa face arrière et présentant une pluralité de pictogrammes fonctionnels indiquant des zones spécifiques de commandes. Un film capacitif est apposé contre la face arrière de la façade frontale de sorte à ce que les zones de commandes forment des boutons de commandes capacitifs. Une carte électronique à circuit imprimé est reliée électriquement au film capacitif et comporte des moyens de contrôle du film capacitif. Pour assurer le rétroéclairage des pictogrammes, des diodes électroluminescentes sont agencées sur la carte à circuits imprimés. Généralement une entretoise est intercalée entre le film capacitif et la carte électronique à circuit imprimé, dans laquelle sont agencées des ouvertures rectangulaires disposées en regard des pictogrammes. Des montants s'étendent vers l'arrière depuis le pourtour de ces ouvertures, avec leurs extrémités libres qui reposent contre la carte électronique en entourant chacune des diodes électroluminescentes. Ces montants permettent de compartimenter le flux lumineux produit par les diodes et d'éviter la dispersion de lumière dans l'ensemble du panneau de commande.

Ce type de dispositif de commande à boutons capacitifs demande un assemblage complexe de différentes pièces de technologies différentes, notamment l'assemblage de pièces plastiques telles que la façade frontale, avec un film capacitif. Le film capacitif représente également une contrainte pour le rétroéclairage, notamment par ses propriétés de propagation de la lumière.

Il est donc important de proposer une solution nouvelle résolvant ces problèmes.

WO2015110722A1 divulgue le préambule de la revendication 1.

### RESUME DE L'INVENTION

Selon l'invention, un panneau de commande pour véhicule automobile comprend une façade frontale comportant une zone de commande, une carte à circuit imprimé, au moins un élément de détection capacitive électriquement conducteur et s'étendant selon un axe vertical depuis la face arrière de la façade frontale jusqu'à une zone de contact électrique de la carte à circuit imprimé, une source de lumière montée sur la carte à circuit imprimé et apte à produire un faisceau lumineux de rétroéclairage vers la zone de commande au travers de l'élément de détection capacitive. L'élément de détection capacitive comprend au moins une partie tubulaire rigide formant un guide de lumière pour le faisceau lumineux et au moins une partie élastique réalisée d'une seule pièce avec la partie tubulaire rigide de sorte à compenser les jeux entre la face arrière et l'élément de détection et entre la carte à circuit imprimé et l'élément de détection.

De préférence, la partie tubulaire rigide peut-être un plastique électriquement conducteur. L'élément de détection capacitive peut comprendre une partie élastique agencée en appui avec la zone de contact électrique de la carte à circuit imprimé. L'élément de détection capacitive peut comprendre une partie élastique agencée en appui au contact direct avec la face arrière de la façade frontale.

Selon un mode de réalisation préféré, l'élément de détection peut comprendre une unique partie élastique agencée entre les extrémités axiales de l'élément de détection de sorte à ce que la partie tubulaire est divisée en une première et une seconde portions de part et d'autre de la partie élastique, la première et la seconde portions étant respectivement en contact en appui avec la face arrière de la façade frontale et en appui avec la zone de contact électrique de la carte à circuit imprimé. La partie élastique peut-être un collier en élastomère conducteur surmoulé avec la partie tubulaire rigide.

Selon un autre mode de réalisation, la partie élastique peut comprendre une forme élastique venue de matière avec la partie tubulaire. La forme élastique peut comprendre au moins un ressort à lame en forme de 'V' dont la pointe du 'V' est orientée vers l'intérieur de la cavité de l'élément de détection, le ressort à lame étant agencé entre les extrémités de l'élément de détection de sorte à ce que la partie tubulaire est divisée en une première et une seconde portions de part et d'autre du ressort à lame, la première et la seconde portions étant respectivement en contact en appui avec la face arrière de la façade frontale et en appui avec la zone de contact électrique de la carte à circuit imprimé. La forme élastique peut avoir une forme en 'Y' retourné, la partie en 'V' retourné assurant le contact avec la zone de contact électrique de la carte à circuit imprimé, la partie vertical du 'Y' retourné assurant la liaison entre la partie tubulaire et la partie élastique.

L'élément de détection capacitive peut s'étendre selon une direction oblique à l'axe vertical depuis la face arrière de la façade frontale jusqu'à la zone de contact électrique de la carte à circuit imprimé.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue en perspective d'un panneau de commande pour véhicule automobile selon l'invention comprenant un premier mode de réalisation des éléments de détection capacitive
- La figure 2 est une vue schématique en coupe axiale selon le plan 2-2 du panneau de commande de la figure 1.
- La figure 3 est une vue en perspective qui représente un élément de détection capacitive selon un second mode de réalisation.
- La figure 4 est une vue en perspective qui représente un élément de détection capacitive selon un troisième mode de réalisation.
- La figure 5 est une vue partielle en perspective de la partie élastique de l'élément de détection de la figure 4, vue de l'intérieur de la cavité.
- La figure 6 est une vue en perspective qui représente un élément de détection capacitive selon un quatrième mode de réalisation.

### DESCRIPTION DES MODES DE REALISATION PREFERES

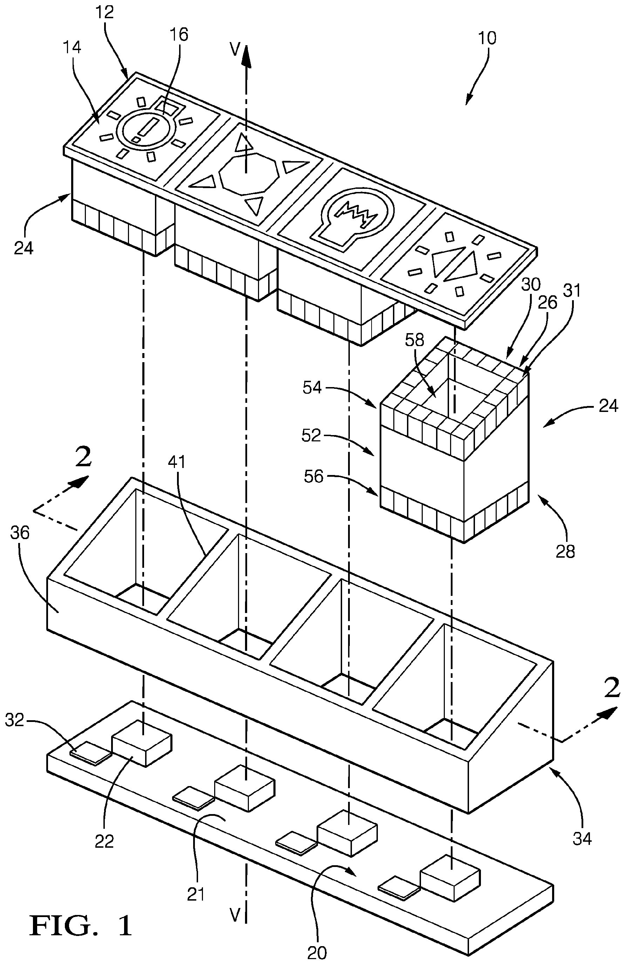

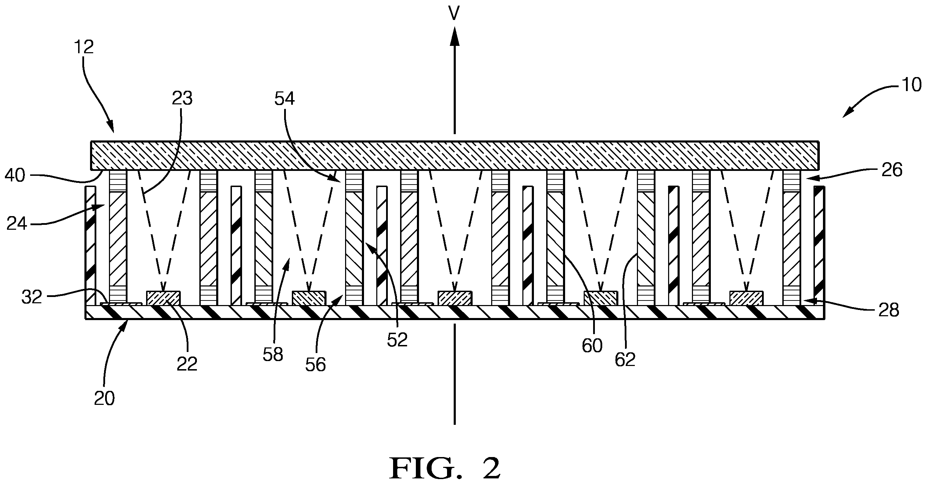

Selon la figure 1 et la figure 2, un panneau de commande 10 pour véhicule automobile comporte une façade frontale 12 comportant des pictogrammes 16. On entend par façade frontale 12, la façade du panneau de commande 10 accessible pour un utilisateur. Des éléments de détection capacitive 24 sont prévus pour être agencés contre la face arrière 40 de la façade frontale 12. De préférence, la façade frontale 12 est un élément unique recouvrant les éléments de détection capacitive 24. Alternativement, la façade frontale 12 peut être constituée d'une pluralité d'éléments recouvrant chacun un ou plusieurs éléments de détection capacitive 24. Le panneau de commande 10 comprend également une carte à circuit imprimé 20 sur laquelle sont disposées des sources de lumière 22 telles que des diodes électroluminescentes. Les diodes, les éléments de détection capacitive 24 et les pictogrammes 16 sont alignés selon un axe vertical V de sorte que les sources de lumière 22 peuvent produire un faisceau lumineux 23 pouvant rétroéclairer les pictogrammes 16 au travers des éléments de détection capacitive 24. La carte à circuit imprimé 20 comprend des zones de contact électrique 32 prévues pour être en contact électrique avec les éléments de détection capacitive 24.

Les pictogrammes 16 indiquent des zones de commande 14 sur lesquelles un utilisateur peut appuyer afin de déclencher une fonction du véhicule. Les pictogrammes 16 peuvent être réalisés par gravures laser sur la façade frontale 12.

Selon un premier mode de réalisation, chaque élément de détection capacitive 24 est de forme tubulaire. Chaque élément de détection capacitive 24 a une section en coupe transversale de forme rectangulaire. Des variantes d'élément de détection capacitive 24 ayant une section en coupe transversale de forme circulaire ou de forme ellipsoïdale sont envisageables. Chaque élément de détection capacitive 24 s'étend selon l'axe vertical V depuis la face arrière 40 de la façade frontale 12 jusqu'à la zone de contact électrique 32 de la carte à circuit imprimé 20. Chaque élément de détection 24 comprend une première extrémité axiale 26 au contact direct avec la face arrière 40 de la façade frontale 12 et une seconde extrémité axiale 28 au contact avec une zone de contact électrique 32 de la carte à circuit imprimé 20.

Chaque première extrémité 26 comporte un rebord 30 dont la surface 31 est entièrement au contact direct avec la face arrière 40 de la façade frontale 12. La surface 40 du rebord 30 de chaque première extrémité 26 est inclinée par rapport à la surface 21 de la carte à circuit imprimé 20 de sorte à être essentiellement parallèle à la face arrière 40 de la façade frontale 12 inclinée vis-à-vis de la carte à circuit imprimé 20 et donc de pouvoir venir entièrement en appui sur la face arrière 40 de la façade frontale 12. Lorsque la façade frontale 12 du panneau de commande 10 est parallèle à la carte à circuit imprimé 20, la surface 31 du rebord 30 de chaque première extrémité 26 est essentiellement parallèle à la carte à circuit imprimé 20. Le rebord 30 de chaque première extrémité 26 entoure chaque zone de commande 14.

Optionnellement, les éléments de détection capacitive 24 peuvent s'étendre selon une direction oblique à l'axe vertical V depuis la face arrière 40 de la façade frontale 12 jusqu'à la zone de contact électrique 32 de la carte à circuit imprimé 20, de sorte à pouvoir s'adapter à un agencement pour lequel les sources de lumière 22 ne sont pas alignées verticalement avec les zones de commande 14.

Selon le mode de réalisation représenté par les figures 1 et 2, chaque élément de détection capacitive comprend une partie tubulaire rigide 52 et également deux parties élastiques électriquement conductrices 54, 56.

Chaque partie tubulaire rigide 52 a une section en coupe transversale de forme rectangulaire. Des variantes de partie tubulaire rigide 52 ayant une section en coupe transversale de forme circulaire ou de forme ellipsoïdale sont envisageables. Chaque partie tubulaire rigide 52 comporte une cavité 58 formant un guide de lumière pour la source de lumière 22. Les parois interne 60, 62 de la cavité 58 réfléchissent la lumière et ne laissent pas la lumière se disperser en dehors de la cavité 58. Chaque partie tubulaire rigide 52 est une pièce plastique électriquement conductrice. De préférence ce sont des pièces formées de plastique chargée en particules métalliques telles que par exemple de la poudre ou des paillettes d'aluminium, de cuivre ou de zinc.

Chaque partie élastique 54, 56 électriquement conductrice est en forme de collier agencé à chaque extrémité axiale 26, 28 de la partie tubulaire 52 de sorte à compenser les jeux entre la face arrière 40 et l'élément de détection 24 et entre la carte à circuit imprimé 20 et l'élément de détection 24. Autrement dit, une des deux parties élastiques 54 est agencée au contact direct en appui avec la face arrière 40 de la façade frontale 12; cette partie élastique 54 étant la première extrémité 26 de l'élément de détection capacitive 24. L'autre partie élastique 56 est agencée au contact direct en appui avec la zone de contact électrique 32 de la carte à circuit imprimé 20; cette partie élastique 56 étant la seconde extrémité 28 de l'élément de détection 24. Chaque élément élastique électriquement conducteur 54, 56 permet de s'affranchir des jeux dus à l'assemblage ou à l'expansion thermique du panneau de commande 10, plus particulièrement de la tolérance de la distance séparant l'élément de détection capacitive 24 avec la carte à circuit imprimé 20 et également de la distance séparant l'élément de détection capacitive 24 avec la face arrière 40 de la façade frontale 12. Cette solution permet donc de garantir un contact électrique entre l'élément de détection capacitive 24 et la carte à circuit imprimé 20, et également entre l'élément de détection capacitive 24 et la face arrière 40 de la façade frontale 12. Chaque partie élastique 54, 56 de chaque élément de détection 24, permet de maintenir ce dernier en compression contre la carte à circuit imprimé 20 et contre la face arrière 40 de la façade frontale 12.

Les deux parties élastiques 54, 56 sont réalisées d'une seule pièce avec la partie tubulaire rigide 52. Chacune des parties élastiques 54, 56 est formée par un collier en élastomère électriquement conducteur et plus particulièrement en caoutchouc.

Chacune des deux parties élastiques 54, 56 peut être de préférence surmoulée avec la partie tubulaire rigide 52, ou collée. Le surmoulage permet de s'affranchir d'une étape de collage, la colle pouvant réduire la sensibilité de la détection capacitive.

Bien que cela ne soit pas indispensable à l'invention, le panneau de commande 10 de la figure 1 comporte également un boîtier 34. Ce boîtier 34 est prévu pour fermer le panneau de commande 10. Le boîtier 34 comprend un bord périphérique 36 prévu pour entourer la carte à circuit imprimé 20 et s'étendant verticalement jusqu'à la façade frontale 12 de sorte à ce que la façade frontale 12 puisse fermer le boîtier 34. Le boîtier 34 comprend également des parois opaques 41 agencées sur la carte à circuit imprimé 20 et disposées entre les sources de lumière 22 de sorte à bloquer toute dispersion de lumière d'une source de lumière 22 vers une autre et également pouvant servir à maintenir les éléments de détection capacitive 24.

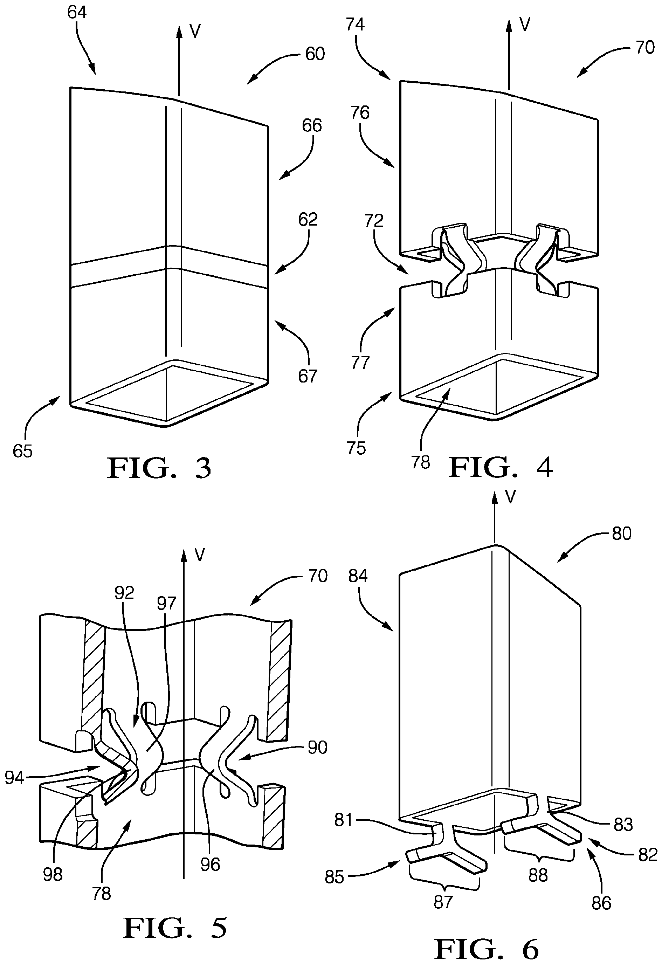

Les figures 3, 4 et 6 représentent d'autres exemples non limitatifs d'éléments de détection capacitive 60, 70, 80 selon l'invention.

Selon un second mode de réalisation, la forme géométrique générale de l'élément de détection capacitive 60 représenté à la figure 3 diffère de celui de la figure 1 en ce qu'il ne comprend qu'une seule partie élastique 62 formé par un collier en caoutchouc électriquement conducteur. Ce collier est placé entre la première 64 et la seconde 65 extrémité de l'élément de détection capacitive 60, séparant ainsi la partie tubulaire rigide en une première 66 et une seconde 67 portions de part et d'autre de la partie élastique 62, la première 66 et la seconde 67 portions étant respectivement prévues pour être en contact en appui avec la face arrière 40 de la façade frontale 12 et en appui avec la zone de contact électrique 32 de la carte à circuit imprimé 20.

Selon un troisième mode de réalisation, la partie élastique 72 de l'élément de détection capacitive 70 représentée à la figure 4 est localisée sur l'élément de détection 70 de façon similaire à celui de la figure 3. Cependant, contrairement à la figure 3, la partie élastique 72 est venue de matière avec la première 76 et la seconde 77 portions de la partie tubulaire rigide, c'est-à-dire de préférence en plastique rigide électriquement conducteur. La propriété élastique de cette partie élastique 72 en plastique rigide est obtenue par la forme particulière de celle-ci. Selon le mode de réalisation représenté sur les figures 4 et 5, la partie élastique 72 est formée par quatre ressorts à lame (3 ressorts représentés sur la figure 5) 90, 92, 94 en forme de 'V' reliant respectivement chacun la première 76 et la seconde 77 portions des quatre parois de l'élément de détection capacitive 24, chaque pointe du 'V' 96, 97, 98 de chacun des ressorts 90, 92, 94 étant orientée vers l'intérieur de la cavité 78 de l'élément de détection 70.

De manière plus générale, la première 76 et la seconde 77 portions de la partie tubulaire rigide peuvent être reliées par un ou plusieurs ressorts à lame venue de matière avec la partie tubulaire rigide.

Selon un quatrième mode de réalisation, et de la même manière que pour la figure 4, la partie élastique 82 de l'élément de détection capacitive 80 représenté à la figure 6 est venue de matière avec la partie tubulaire rigide 84. Cependant, la figure 6 se différencie de la figure 4 en ce que l'élément élastique 82 est agencé à l'extrémité de l'élément de détection 80 prévue pour être en contact avec une zone de contact électrique 32 de la carte à circuit imprimé 20. En d'autres termes, cette partie élastique 82 venue de matière avec la partie tubulaire 84 est prévue pour être maintenue en appui par compression sur une zone de contact électrique 32 de la carte à circuit imprimé 20. La partie élastique 82 est formée de deux éléments élastique 85, 86 en vis-à-vis agencés en continuité avec respectivement deux parois en vis-à-vis de la partie tubulaire rigide 84. Chaque élément 85, 86 a une forme en 'Y' retourné, chaque partie en 'V' retourné 87, 88 assurant le contact avec la zone de contact électrique 32 de la carte à circuit imprimé 20, chaque partie vertical 81, 83 du 'Y' retourné assurant la liaison entre la partie tubulaire 84 et chaque élément élastique 85, 86.

De manière plus générale, la partie tubulaire rigide 84 peut être reliée électriquement à une zone de contact électrique 32 de la carte à circuit imprimé 20 par un ou plusieurs ressorts à lame ou pattes élastiques 85, 86 venue de matière avec la partie tubulaire rigide 84.

L'invention ne se limite pas aux exemples d'éléments de détection représentés, mais peut s'étendre à des éléments de détection pour lesquels la partie tubulaire peut avoir une section en coupe transversale de forme circulaire ou d'autres formes. La forme élastique des parties élastiques venues de matière avec la partie tubulaire rigide peut également être différente de celles représentées ; la fonction essentielle de cette partie élastique est d'assurer le maintien de l'élément de détection en appui par compression contre la carte à circuit imprimé et contre la face arrière de la façade frontale du panneau de commande. Le nombre de partie élastique peut également être supérieur à deux si le rattrapage des jeux d'assemblage entre les éléments de détection et le panneau de commande l'exige.

## Revendications

1. Panneau de commande (10) pour véhicule automobile comprenant :
une façade frontale (12) comportant une zone de commande (14);
une carte à circuit imprimé (20);
au moins un élément de détection capacitive (24) électriquement conducteur et s'étendant selon un axe vertical (V) depuis la face arrière (40) de la façade frontale (12) jusqu'à une zone de contact électrique (32) de la carte à circuit imprimé (20);
une source de lumière (22) montée sur la carte à circuit imprimé (20) et apte à produire un faisceau lumineux (23) de rétroéclairage vers la zone de commande (14) au travers de l'élément de détection capacitive;
**caractérisé en ce que**
l'élément de détection capacitive (24) comprend au moins une partie tubulaire rigide (52) formant un guide de lumière pour le faisceau lumineux (23) et au moins une partie élastique (54) réalisée d'une seule pièce avec la partie tubulaire rigide (52) de sorte à compenser les jeux entre la face arrière (40) et l'élément de détection (24) et entre la carte à circuit imprimé (20) et l'élément de détection (24).

2. Panneau de commande (10) selon la revendication 1 **caractérisé en ce que** la partie tubulaire rigide (52) est un plastique électriquement conducteur.

3. Panneau de commande (10) selon l'une quelconque des revendications précédentes **caractérisé en ce que** l'élément de détection (24) comprend une partie élastique agencée (56) en appui avec la zone de contact électrique (32) de la carte à circuit imprimé (20).

4. Panneau de commande (10) selon l'une quelconque des revendications précédentes **caractérisé en ce que** l'élément de détection (24) comprend une partie élastique (54) agencée en appui au contact direct avec la face arrière (40) de la façade frontale (12).

5. Panneau de commande (10) selon l'une quelconque des revendications 1 à 2 **caractérisé en ce que** l'élément de détection (60) comprend une unique partie élastique (62) agencée entre les extrémités axiales (64, 65) de l'élément de détection (60) de sorte à ce que la partie tubulaire est divisée en une première (66) et une seconde (67) portions de part et d'autre de la partie élastique (62), la première (66) et la seconde (67) portions étant respectivement en contact en appui avec la face arrière (40) de la façade frontale (12) et en appui avec la zone de contact électrique (32) de la carte à circuit imprimé (20).

6. Panneau de commande (10) selon l'une quelconque des revendications précédentes **caractérisé en ce que** la partie élastique (54, 56, 62) est un collier en élastomère conducteur surmoulé avec la partie tubulaire rigide (52, 66, 67).

7. Panneau de commande (10) selon l'une quelconque des revendications 1 à 2 **caractérisé en ce que** la partie élastique (72) comprend une forme élastique venue de matière avec la partie tubulaire (76, 77).

8. Panneau de commande (10) selon la revendication 7 **caractérisé en ce que** la forme élastique (72) comprend au moins un ressort à lame (90) en forme de 'V' dont la pointe du 'V' (96) est orientée vers l'intérieur de la cavité (78) de l'élément de détection (70), le ressort à lame (90) étant agencé entre les extrémités (74, 75) de l'élément de détection (70) de sorte à ce que la partie tubulaire est divisée en une première (76) et une seconde (77) portions de part et d'autre du ressort à lame (90), la première (76) et la seconde (77) portions étant respectivement en contact en appui avec la face arrière (40) de la façade frontale (12) et en appui avec la zone de contact électrique (32) de la carte à circuit imprimé (20).

9. Panneau de commande (10) selon la revendication 7 **caractérisé en ce que** la forme élastique (85, 86) a une forme en 'Y' retourné, la partie en 'V' retourné (87, 88) assurant le contact avec la zone de contact électrique (32) de la carte à circuit imprimé (20), la partie vertical du 'Y' retourné (81, 83) assurant la liaison entre la partie tubulaire (84) et la partie élastique (85, 86).

10. Panneau de commande (10) selon l'une quelconque des revendications précédentes **caractérisé en ce que** l'élément de détection capacitive (54) s'étend selon une direction oblique à l'axe vertical (V) depuis la face arrière (40) de la façade frontale (12) jusqu'à la zone de contact électrique (32) de la carte à circuit imprimé (20).

## Patentansprüche

1. Bedienfeld (10) für Kraftfahrzeuge, enthaltend:
eine Frontwand (12) mit einem Bedienbereich (14);
eine gedruckte Leiterplatte (20);
zumindest ein kapazitives Erfassungselement (24), das elektrisch leitfähig ist und sich entlang einer vertikalen Achse (V) von der Rückseite (40) der Frontwand (12) bis zu einem elektrischen Kontaktbereich (32) der gedruckten Leiterplatte (20) erstreckt;
eine Lichtquelle (22), die an der gedruckten Leiterplatte (20) angebracht und dazu geeignet ist, einen Lichtstrahl (23) zur Hinterleuchtung in Richtung Bedienbereich (14) durch das kapazitive Erfassungselement hindurch zu erzeugen;
**dadurch gekennzeichnet, dass**
das kapazitive Erfassungselement (24) zumindest ein starres Rohrteil (52) enthält, das einen Lichtleiter für den Lichtstrahl (23) bildet, und zumindest ein elastisches Teil (54), das aus einem Stück mit dem starren Rohrteil (52) ausgebildet ist, so dass ein jeweiliges Spiel zwischen der Rückseite (40) und dem Erfassungselement (24) und zwischen der gedruckten Leiterplatte (20) und dem Erfassungselement (24) ausgeglichen wird.

2. Bedienfeld (10) nach Anspruch 1,
**dadurch gekennzeichnet, dass**
das starre Rohrteil (52) aus elektrisch leitfähigem Kunststoff besteht.

3. Bedienfeld (10) nach einem der vorangehenden Ansprüche,
**dadurch gekennzeichnet, dass**
das Erfassungselement (24) ein elastisches Teil (56) in Anlage mit dem elektrischen Kontaktbereich (32) der gedruckten Leiterplatte (20) enthält.

4. Bedienfeld (10) nach einem der vorangehenden Ansprüche,
**dadurch gekennzeichnet, dass**
das Erfassungselement (24) ein elastisches Teil (54) enthält, das in direktem Kontakt mit der Rückseite (40) der Frontwand (12) angeordnet ist.

5. Bedienfeld (10) nach einem der Ansprüche 1 bis 2,
**dadurch gekennzeichnet, dass**
das Erfassungselement (60) ein einziges elastisches Teil (62) enthält, das zwischen den axialen Enden (64, 65) des Erfassungselements (60) angeordnet ist, so dass das Rohrteil in einen ersten (66) und einen zweiten (67) Abschnitt beiderseits des elastischen Teils (62) unterteilt ist, wobei der erste (66) und der zweite (67) Abschnitt jeweils in Anlage mit der Rückseite (40) der Frontwand (12) bzw. in Anlage mit dem elektrischen Kontaktbereich (32) der gedruckten Leiterplatte (20) in Kontakt sind.

6. Bedienfeld (10) nach einem der vorangehenden Ansprüche,
**dadurch gekennzeichnet, dass**
das elastische Teil (54, 56, 62) eine Schelle aus leitfähigem Elastomer ist, das mit dem starren Rohrteil (52, 66, 67) umformt ist.

7. Bedienfeld (10) nach einem der Ansprüche 1 bis 2,
**dadurch gekennzeichnet, dass**
das elastische Teil (72) eine elastische Form hat, die stoffschlüssig mit dem Rohrteil (76, 77) ausgebildet ist.

8. Bedienfeld (10) nach Anspruch 7,
**dadurch gekennzeichnet, dass**
die elastische Form (72) zumindest eine V-förmige Blattfeder (90) enthält, deren V-Spitze (96) nach innerhalb des Hohlraums (78) des Erfassungselements (70) gerichtet ist, wobei die Blattfeder (90) zwischen den Enden (74, 75) des Erfassungselements (70) angeordnet ist, so dass das Rohrteil in einen ersten (76) und einen zweiten (77) Abschnitt beiderseits der Blattfeder (90) unterteilt ist, wobei der erste (76) und der zweite (77) Abschnitt jeweils in Anlage mit der Rückseite (40) der Frontwand (12) bzw. in Anlage mit dem elektrischen Kontaktbereich (32) der gedruckten Leiterplatte (20) in Kontakt sind.

9. Bedienfeld (10) nach Anspruch 7,
**dadurch gekennzeichnet, dass**
die elastische Form (85, 86) eine umgekehrte Y-Form hat, wobei der umgekehrt V-förmige Teil (87, 88) den Kontakt mit dem elektrischen Kontaktbereich (32) der gedruckten Leiterplatte (20) sicherstellt und der vertikale Teil der umgekehrten Y-Form (81, 83) die Verbindung zwischen dem Rohrteil (84) und dem elastischen Teil (85, 86) sicherstellt.

10. Bedienfeld (10) nach einem der vorangehenden Ansprüche,
**dadurch gekennzeichnet, dass**
das kapazitive Erfassungselement (54) sich in einer Richtung schräg zur vertikalen Achse (V) ausgehend von der Rückseite (40) der Frontwand (12) bis zum elektrischen Kontaktbereich (32) der gedruckten Leiterplatte (20) erstreckt.

## Claims

1. Motor vehicle control panel (10) comprising:
a front face (12) including a control zone (14);
a printed circuit card (20);
at least one electrically conductive capacitive detection element (24) extending along a vertical axis (V) from the rear surface (40) of the front face (12) to an electrical contact zone (32) of the printed circuit card (20);
a light source (22) mounted on the printed circuit card (20) and able to produce a back-lighting light beam (23) toward the control zone (14) through the capacitive detection element;
**characterized in that**
the capacitive detection element (24) comprises at least one rigid tubular part (52) forming a light guide for the light beam (23) and at least one elastic part (54) made in one piece with the rigid tubular part (52) so as to compensate the clearances between the rear surface (40) and the detection element (24) and between the printed circuit card (20) and the detection element (24) .

2. Control panel (10) according to Claim 1 **characterized in that** the rigid tubular part (52) is an electrically conductive plastic.

3. Control panel (10) according to either one of the preceding claims **characterized in that** the detection element (24) comprises an elastic part (56) arranged in bearing engagement with the electrical contact zone (32) of the printed circuit card (20).

4. Control panel (10) according to any one of the preceding claims **characterized in that** the detection element (24) comprises an elastic part (54) arranged in direct contact bearing engagement with the rear surface (40) of the front face (12).

5. Control panel (10) according to any either one of Claims 1 or 2 **characterized in that** the detection element (60) comprises a single elastic part (62) arranged between the axial ends (64, 65) of the detection element (60) so that the tubular part is divided into a first portion (66) and a second portion (67) on respective opposite sides of the elastic part (62), the first portion (66) and the second portion (67) being respectively in contact bearing engagement with the rear surface (40) of the front face (12) and in bearing engagement with the electrical contact zone (32) of the printed circuit card (20).

6. Control panel (10) according to any one of the preceding claims **characterized in that** the elastic part (54, 56, 62) is a conductive elastomer collar overmoulded with the rigid tubular part (52, 66, 67).

7. Control panel (10) according to either one of Claims 1 or 2 **characterized in that** the elastic part (72) comprises an elastic shape made in one piece with the tubular part (76, 77).

8. Control panel (10) according to Claim 7 **characterized in that** the elastic shape (72) comprises at least one V-shaped leaf spring (90) with the point of the V-shape (96) oriented toward the interior of the cavity (78) of the detection element (70), the leaf spring (90) being arranged between the ends (74, 75) of the detection element (70) so that the tubular part is divided into a first portion (76) and a second portion (77) on respective opposite sides of the leaf spring (90), the first portion (76) and the second portion (77) being respectively in contact bearing engagement with the rear surface (40) of the front face (12) and in bearing engagement with the electrical contact zone (32) of the printed circuit card (20).

9. Control panel (10) according to Claim 7 **characterized in that** the elastic shape (85, 86) has an inverted Y-shape, the inverted V-shaped part (87, 88) making the contact with the electrical contact zone (32) of the printed circuit card (20), the vertical part of the inverted Y-shape (81, 83) making the connection between the tubular part (84) and the elastic part (85, 86) .

10. Control panel (10) according to any one of the preceding claims **characterized in that** the capacitive detection element (54) extends in a direction oblique to the vertical axis (V) from the rear surface (40) of the front face (12) to the electrical contact zone (32) of the printed circuit card (20).
